# EUROPEAN PATENT SPECIFICATION

(11) **EP 1 811 572 B1**
(45) Date of publication and mention of the grant of the patent: **30.05.2012**
(21) Application number: 07009037.8
(22) Date of filing: 11.02.2000
(51) Int. Cl.: H01L 29/739, H01L 29/06, H01L 23/528, H02M 7/527

(54) **Semiconductor device and power converter using the same**
Halbleiterelement und Stromwandler mit einem solchen Halbleiterelement
Dispositif à semi-conducteur et convertisseur de puissance utilisant ce même dispositif à semi-conducteur

(30) Priority: 17.02.1999 JP 3816699
(43) Date of publication of application: 25.07.2007
(62) Divisional of application: 00301097.2
(73) Proprietor: Hitachi, Ltd., Chiyoda-ku Tokyo (JP)
(72) Inventor: Oyama, Kazuhiro, Hitachi-shi Ibaraki (JP); Sakano, Jyunichi, Hitachi-shi Ibaraki (JP); Mori, Mutsuhiro, Hitachi-shi Ibaraki (JP)
(74) Representative: Calderbank, Thomas Roger

(56) References cited:
- EP-A- 0 746 030
- EP-A- 0 847 090
- EP-A- 0 889 531
- EP-A1- 0 527 600
- JP-A- 9 275 252
- PATENT ABSTRACTS OF JAPAN vol. 1996, no. 09, 30 September 1996 (1996-09-30) & JP 08 116056 A (HITACHI LTD), 7 May 1996 (1996-05-07)

## Description

The present invention relates to a semiconductor device and particularly to an insulating gate type bipolar transistor having a trench insulating gate structure and a power converter using it.

An insulating gate type bipolar transistor (hereinafter abbreviated to IGBT) is conventionally known as a power semiconductor element. During the ON operation, the pnp transistor operates and the conductivity is modulated, so that the IGBT has an advantage that the ON voltage can be lowered. However, it is a transistor operation, so that the conductivity modulation is not sufficient compared with the thyristor operation and the ON voltage is high compared with the GTO thyristor.

Recently, the trench insulating gate type IGBT is begun to be noticed as a power semiconductor element. The trench type IGBT has a structure that the insulating gate is embedded in the semiconductor. As a basic constitution, on one surface of the n-type base layer of high resistance, the p-type collector layer is formed across the n-type buffer layer. On the other surface of the n-type base layer, the p-type base layer is formed. On the p-type base layer, trench gate electrodes having a plurality of same shapes that the plane shape is changed to a stripe shape are formed. The trench electrodes are in a shape that the electrodes and their surroundings are covered with an insulating film. Therefore, the trench gate electrodes are structured so that their side walls are MOS channels.

In the trench insulating gate type IGBT, the insulating gates can be formed densely compared with the planar IGBT, so that the channel width is wider and the channel resistance is low. As a result, compared with the conventional planar IGBT, a low ON voltage (ON voltage: saturation voltage between the collector and the emitter) is obtained.

In the trench insulating gate type IGBT, as the channel width increases, the saturation current increases and the short-circuit withstand amount reduces.

The structure using trench insulating gates is described in Japanese Patent Application Laid-Open 5-243561. This is a structure that the injection effect of holes into the n-type base layer is increased. Concretely, in the trench insulating gate type IGBT having trench insulating gates formed at equal intervals or widely, the number of channels formed on the side walls of the trench insulating gates are reduced and the channel width is narrowed. Furthermore, the p-type base layer which is positioned on the other surface on the side where no channels are formed is covered with an insulating film and isolated from the main electrode. It is said that this structure increases the injection effect and provides a conductivity modulation closeto that of the thyristor. As a result, although the channel resistance increases, the resistance when the n-type base layer is used reduces and a low ON voltage is obtained. However, since the gate input capacity is large and hence the switching is slow, a problem arises that the switching loss is large particularly in high frequency waves. A problem also arises that the drive power is large.

A structure for solving such problems is described in Japanese Patent Application Laid-open 10-178176. The characteristic of this structure is that the interval of the gates forming no channels is wider than the interval of the gates forming channels and such a status is repeated.

By doing this, the gate input capacity, switching loss, and drive power can be reduced. However, to reduce the loss sufficiently, it is necessary to widen the interval of the gates forming no channels and a problem arises that the withstand voltage of the element reduces.

European Application EP 0 847 090 A2 discloses another IGBT in which the interval of the gates forming no channel is wider than the interval of the gates forming channels.

The present invention has been developed in consideration of the aforementioned problems and provides a semiconductor device of the trench insulating gate type for improving the electric characteristics as described in claim 1.

The semiconductor device of the present invention can be used for a power converter for converting the power by turning the semiconductor switching element on or off. The power converter has a pair of DC terminals, a plurality of series connection circuits connected between the DC terminals in which a plurality of semiconductor switching elements are connected in series, and a plurality of AC terminals connected to each DC series connection point of a plurality of DC connection circuits. These plurality of semiconductor switching elements are the semiconductor device of the present invention. According to this power converter, the reliability and efficiency of a power converter can be improved. As a power converter, there are an invertor for converting the DC power to an AC power and a converter for converting the AC power to a DC power.

### In the drawings:

Fig. 1 is a cross sectional view for explaining the constitution of the first embodiment relating to the present invention.

Fig. 2 is a graph for explaining the effect of the embodiment.

Fig. 3 is a cross sectional view for explaining the constitution of the second embodiment relating to the present invention.

Fig. 4 is a cross sectional view for explaining the constitution of an example useful for understanding the present invention.

Fig. 5 is a plan view for explaining the terminal constitution of the first embodiment relating to the present invention.

Fig. 6 is a cross sectional view of A-A' shown in Figs. 5, 8, and 9.

Fig. 7 is a cross sectional view of B-B' shown in Figs. 5, 8, and 9.

Fig. 8 is a plan view for explaining the trench gate structure relating to the present invention.

Fig. 9 is a plan view for explaining the trench gate structure relating to the present invention.

Fig. 10 is a cross sectional view for explaining an embodiment of a crimp type element relating to the present invention.

Fig. 11 is a cross sectional view for explaining an embodiment of another crimp type element relating to the present invention.

Fig. 12 is a circulation diagram for explaining an embodiment of a 3-phase invertor using an insulating gate type trench type IGBT relating to the present invention.

Fig. 13 is a plan view of the seventh embodiment relating to the present invention.

Fig. 14 is a cross sectional view of A-A' shown in Fig. 13.

Fig. 15 is a cross section view of the eighth embodiment relating to the present invention.

Fig. 16 is a solid perspective view of an example useful for understanding the present invention.

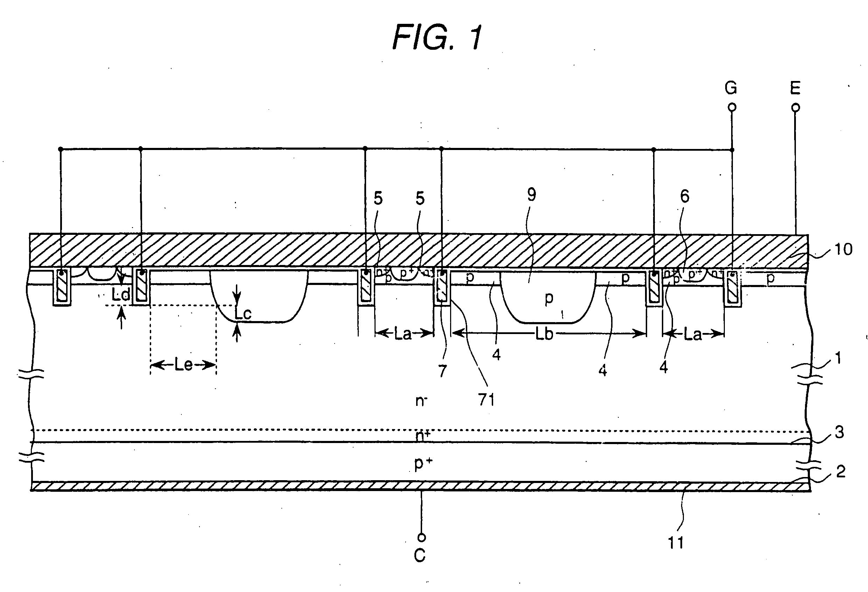

Fig. 1 shows the first embodiment of the present invention and a cross sectional view of a cell of a trench insulating gate type IGBT.

On the trench insulating gate type IGBT, on one surface of the n-type base layer 1 (second semiconductor layer) of high resistance, the p-type collector layer 2 (first conductor layer) is formed across the n-type buffer layer 3 whose impurity density is higher than that of the n-type base layer 1. On the other surface of the n-type base layer 1, the p-type base layer (third semiconductor layer) is formed.

On the p-type base layer 4, a plurality of trench insulating gate electrodes 7 (insulating gates) having the same shape that the plane shape is striped are formed so deep that they reach the n-type base layer 1. The trench insulating gate electrodes 7 are shapes so that the gate electrodes are embedded in the groove reaching the n-type base layer 1 from the surface of the p-type base layer 4 and the periphery of the gate electrodes is covered with an insulating film. These trench insulating gate electrodes 7 are structured so that as to the mutual intervals of neighboring trench insulating gates, the narrow La and wide Lb appear alternately. According to this embodiment, the mutual intervals are indicated with the side wall of the trench groove as the starting point. However, the center in the direction of the width of the trench insulating gates may be used as the starting point.

In the area La, the n-type source layer 5 (fourth semiconductor layer) whose impurity density is higher than that of the p-type base layer 4 is formed by impurity diffusion so that the plane shape is striped in contact with trench insulating gates. By doing this, the n-type MOSFET portion which is a channel area where the side of the p-type base layer 4 is controlled by the trench gate electrodes 7 is structured. In the area La, the p+ layer 6 whose impurity density is higher than that of the p-type base layer 4 is formed across the n-type source layer 5 deeper than the n-type source layer 5.

In the area Lb, the p-type base layer 4 is formed in the same depth as the area La so as to be separated from the p-type base layer in the area La and also at the center of the p-type base layer 4, the p-type well layer 9 (fifth semiconductor layer) is formed deeper than the p-type base layer 4 and equally deep to or deeper (Lc ≧ 0) than the trench insulating gate electrodes 7. The distance Le between the trench gate electrodes 7 at the bottom of the trench gate electrodes 7 and the p-type well layer 9 is set sufficiently wide so that the withstand voltage of the element is not lowered.

The main electrode 10 (emitter electrode, first main electrode), in the area La, touches the n-type source layer 5 and the p+ layer 6 at the same time. The other main electrodes 11 (collector electrodes, second main electrodes) touch the p-type collector layer 2. In the area Lb, the main electrode 10 is insulated from the p-type base layer 4 and the p-type well layer 9 by an insulating film.

The operation of this embodiment is described below. The voltage is applied so that the potential of the main electrodes 11 is set higher than the potential of the main electrode 10 and the potential of the trench insulating gate electrodes 7 is set higher than the potential of the main electrode 10. When the voltage of the trench insulating gate electrodes 7 is more than the threshold voltage, an n-type channel is formed on the surface in contact with the gate insulating film of the p-type base layer 4 and electrons flow into the n-type base layer 1 via the channel from the n-type source layer 5 and the n-type base layer 1 is turned on. In this case, holes are injected into the n-type base layer 1 from the p-type collector layer 2 and a conductivity modulation is generated in the n-type base layer 1. In this embodiment, no channel is formed in the area Lb, so that a deep conductivity modulation is generated. Therefore, the element of this embodiment has characteristics of low ON voltage. Furthermore, when La < Lb is set, the area occupied by the gates is reduced, so that the gate input capacity can be made smaller. In this embodiment, although the main continuity area is the area La, since the p-type collector layer 2 extends from the area La to the area Lb, holes are injected also from the p-type collector layer 2 in the area Lb into the n-type base layer 1. The holes also contribute to conductivity modulation. The main electrodes 11 are in ohmic contact with the p-type collector layer 2 also in the area Lb, so that more holes are injected from the p-type collector layer 2 in the area Lb.

The channel resistance is almost inversely proportional to the channel width. In this embodiment, the channel width is smaller than that of a conventional trench IGBT and the channel resistance is increased. However, by use of the structure of this embodiment, the ON voltage of the n-type base layer 1 is reduced and the incremented part of the channel resistance is canceled out. As a result, although the input capacity of gates is low, a low ON voltage can be obtained.

In the OFF state, the withstand voltage is held by junction of the n-type base layer 1 and the p-type base layer 4. Since the trench insulating gates 7 are projected into the n-type base layer 1, the electric field intensity is high at the corner of the trench insulating gates 7. When Lb > La, the electric field intensity is high in the area Lb. When the withstand voltage of the element is higher, to ensure sufficient loss reduction and short-circuit withstand amount, it is valid to widen the area Lb. When the area Lb is widened so that the withstand voltage of the element is decided by the electric field intensity in the area Lb, the withstand voltage of the element is lowered. When the depth Lc from the bottom of the trench insulating gates 7 of the p-type well layer 9 is set like Lc ≧0 and the distance Le between the trench insulating gates 7 and the p-type well layer 9 is adjusted, the electric field intensity in the area Lb can be lowered, so that the withstand voltage of the element will not be lowered.

In the load short-circuit state, the n-type channel MOSFET positioned in the area La is pinched off and a saturation current flows in the main electrode 10 and the main electrodes 11. The saturation current is almost proportional to the channel width. Since the channel width is smaller than that of a conventional trench IGBT, the saturation current is lower than that of a conventional trench insulating gate type IGBT.

According to this embodiment, the input capacity of gates can be reduced. Since the total area of the element of gate insulating film is small, the embodiment also has an advantage at the same time that the manufacturing yield of element is improved.

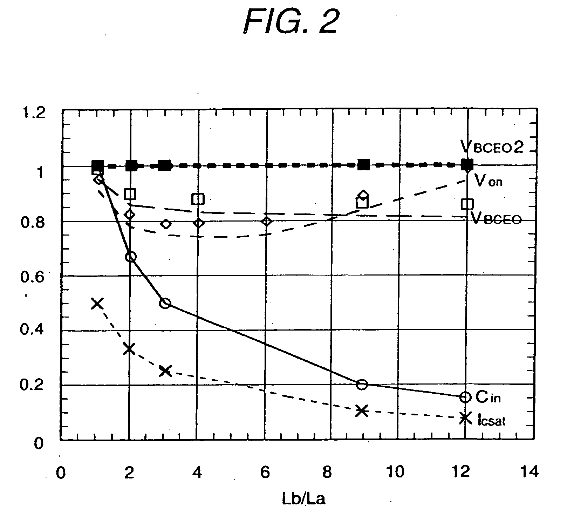

Here, for comparison of this embodiment with a conventional trench insulating gate type IGBT, the dependency on the characteristic interval ratio (Lb/La) is shown in Fig. 2. The values are indicated under the condition that the conventional trench insulating gate IGBT is standardized to 1. In the drawing, the dependency of the ON voltage (Von), gate input capacity (Cin), saturation current (Icsat), and element withstand voltage (VBCEO, VBCEO2) on the interval ratio of this embodiment is shown. The element withstand voltage VBCEO2 is, as shown in Fig. 1, the one when the p-type well layer 9 is formed in the area Lb and the element withstand voltage VBCEO is the one when the p-type well layer 9 is not formed and the p-type base layer is formed continuously. The examination of the inventors of the present invention shows that the ON voltage, gate input capacity, and saturation current have the dependency on the interval ratio (Lb/La) as shown in Fig. 2 regardless of the existence of the p-type well layer.

The examination of the inventors of the present invention shows that when La ≦ 5 µm is satisfied, the trend characteristic shown in Fig. 2 is obtained. When Lb/La > 1, as Lb/La increases, the input capacity Cin and the saturation current Icsat decrease and when Lb/La = 12, they are almost minimized. Namely, when Lb/La > 1 , the high-speed switching performance of the trench insulating gate type IGBT and the short-circuit withstand amount are improved. Furthermore, when 12 > Lb/La > 1, the original property of the trench insulating gate type which is the low ON resistance is not impaired but rather improved, so that the input capacity Cin and the saturation current Icsat decrease. Furthermore, when 6 ≧ Lb/La ≧ 2 is set, the ON voltage is minimized.

As shown in Fig. 2, when the p-type well layer 9 is not formed in the IGBT shown in Fig. 1 and Lb/La is increased, the element withstand voltage VBCEO is lowered. However, if such reduction in the element withstand voltage VBCEO produces no practical effect, even if the p-type well layer 9 is not formed, the aforementioned effect of increasing Lb/La can be produced. On the other hand, as shown by VBCEO2 in the drawing, when the p-type well layer 9 is formed, even if Lb/La is increased, the element withstand voltage changes little. Therefore, the aforementioned reduction in the ON voltage by Lb/La is more valid.

Generally, in a power converter such as an invertor, for a power short-circuit when an accident occurs, by interrupting the current by the IGBT, excessive destruction of the invertor is prevented. To realize it, it is desired that the IGBT withstands for more than 10 microseconds in the short-circuit state independently of the capacity of the invertor, power source, and voltage. The examination of the inventors of the present invention shows that in the IGBT of this embodiment, to realize more than 10 microseconds, it is desirable to control the saturation current density to 1000 A/cm² or less. For example, in an element having a withstand voltage of 600 V, when La = 3.2 µm and Lb = 23.2 µm, the ON voltage is lower than that of a conventional trench insulating gate IGBT, and the gate input capacity is reduced such as 1/3 times, and the saturation current is set to 1000 A/cm².

In an element having a withstand voltage of 1200 V, Lb is made wider such as 31.8 µm. The saturation current is set to 750 A/cm². Therefore, to ensure the short-circuit withstand amount for the two elements, it is not necessary to integrate an IC for limiting the maximum current in the IGBT chip and add it to the outside. As a result, there is an advantage that compared with a conventional trench insulating gate IGBT, the manufacturing cost can be reduced.

As mentioned above, by use of the structure of this embodiment that trench insulating gates are arranged at different intervals, and channels are formed in the wider trench mutual intervals, and the p-type well layer is formed in the wider trench mutual intervals, an insulating gate type bipolar transistor that the reduction in the element withstand voltage is not accompanied, and the gate input capacity is reduced compared with that of a conventional IGBT that trench insulating gates are arranged at equal intervals, and the switching loss is reduced, and the saturation current is lower than that of a conventional trench insulating gate type IGBT at the low ON voltage equivalent to that of the trench insulating gate type IGBT can be realized. Namely, an element having the structure of this embodiment is not accompanied by a reduction in the element withstand voltage and has a small loss even in the high frequency area.

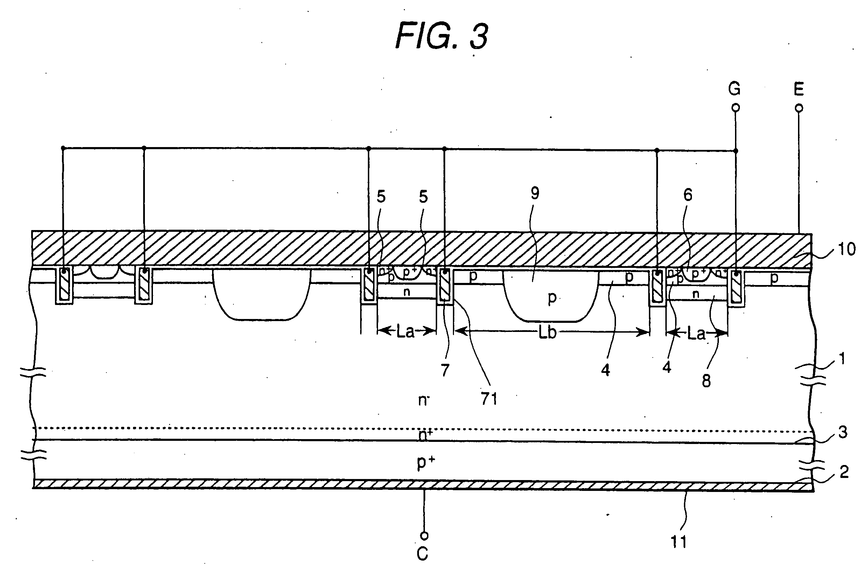

Fig. 3 shows the second embodiment of the present invention and the basic constitution thereof is the same as that of the first embodiment. According to this embodiment, between the p-type base layer 4 and the n-type base layer 1 positioned in the area La, the n-type semiconductor layer 8 whose impurity density is higher than that of the n-type base layer 1 is installed. To form the uniform n-type semiconductor layer 8 under the p-type base layer 4, a part of the n-type semiconductor layer 8 may be extended into the area Lb or extended under the bottom of the trench insulating gates 7.

Holes injected into the n-type base layer 1 from the p-type collector layer 2 are ejected from the n-type source layer 5 in the area La. By the n-type semiconductor layer 8 in the hole movement path, the holes are limited to movement to the p-type base layer 4 and accumulated in the n-type base layer 1 in the neighborhood of the n-type semiconductor layer 8 and hence the conductivity modulation is promoted. As a result, the reduction in the ON voltage is realized. In the turn OFF state, a high voltage is applied to the main electrodes 11 and the n-type semiconductor layer 8 is depleted, so that it causes no obstacles to passing of holes and the turn-off loss is not increased.

The element withstand voltage depends on the impurity density in the n-type semiconductor layer 8. The reason is that the electric field intensity in the neighborhood of the junction of the p-type base layer 4 and the n-type semiconductor layer 8 depends on the impurity density in the n-type semiconductor layer 8. The examination of the inventors of the present invention shows that as the impurity density in the n-type semiconductor layer 8 increases, the ON voltage lowers. However, when it exceeds 1 × 10¹²/cm², the element withstand voltage reduces greatly. Therefore, it is desirable to control the carrier density in the n-type semiconductor layer 8 to 1 × 10¹²/cm² or less.

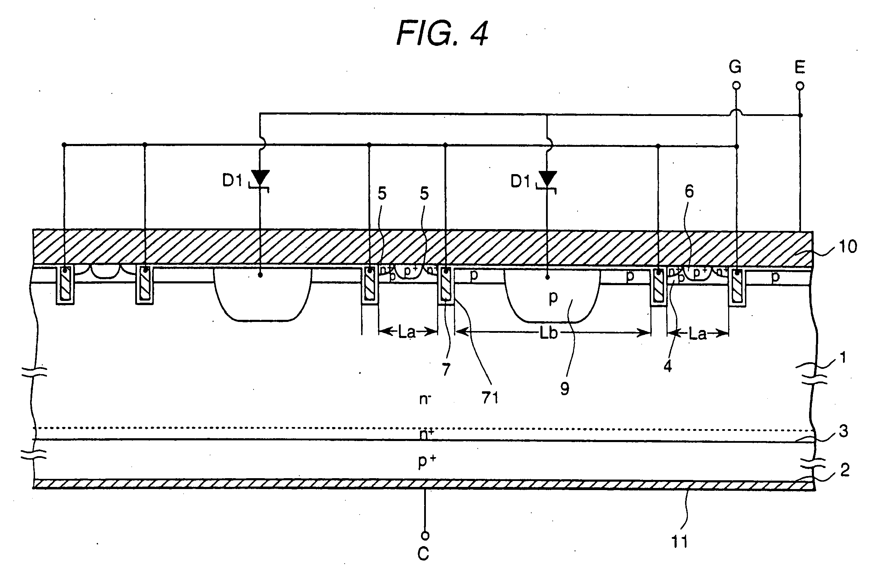

Fig. 4 shows an example useful for understanding the present invention and the basic constitution thereof is the same as that of the first embodiment. According to this embodiment, a Zener diode D1 is connected between the p-type well layer 9 and the main electrode 10.

According to this embodiment, by installing a Zener diode D1 between the p-type base layer 4 and the main electrode 10, the upper limit of the potential between the trench insulating gates 7 and the p-type base layer 4 positioned in the area Lb can be set and generation of an electrostatic concentration exceeding the withstand voltage of the insulating film 71 can be prevented. During turn-off, holes in the n-type base layer 4 pass the p-type well layer 9 and flow into the main electrode 10. Therefore, holes in the n-type base layer 4 can be reduced and the turn-off loss can be reduced. Furthermore, since holes ejected from the n-type source layer 4 in the area La can be reduced, latch-up can be prevented.

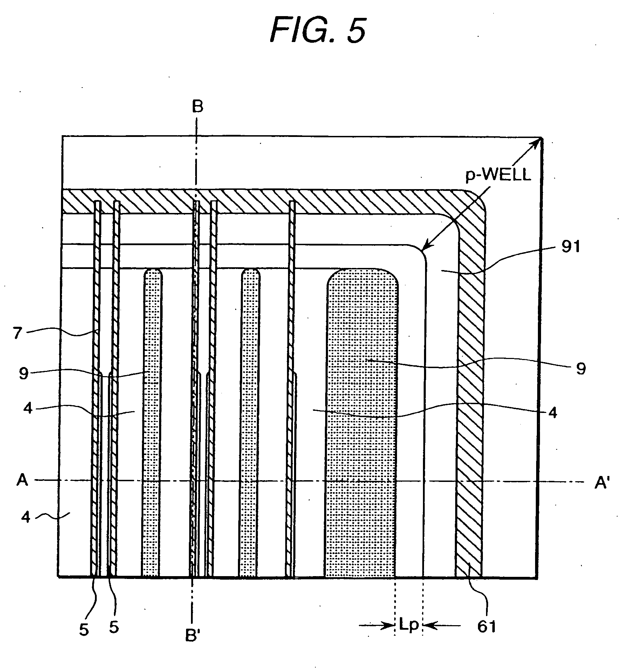

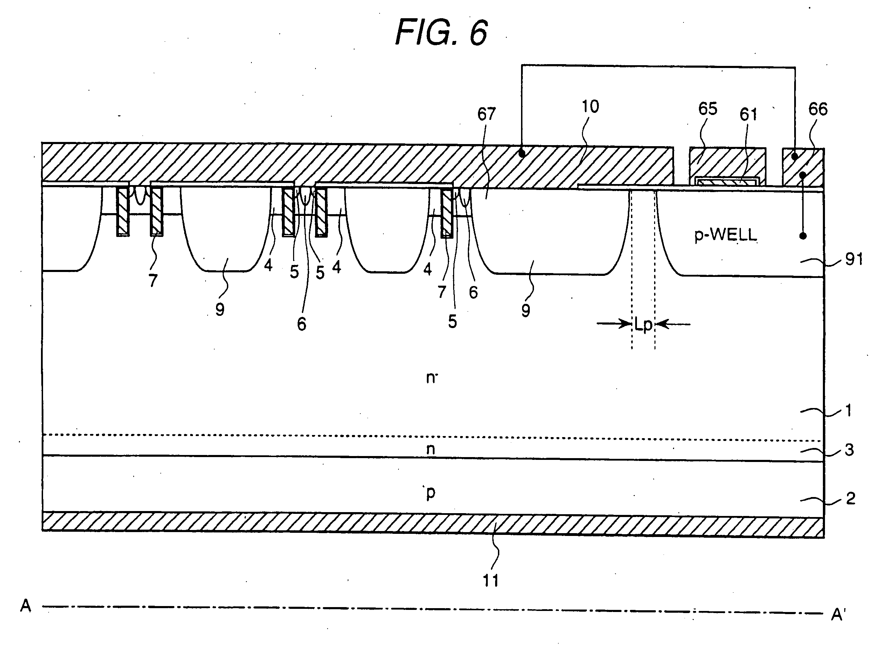

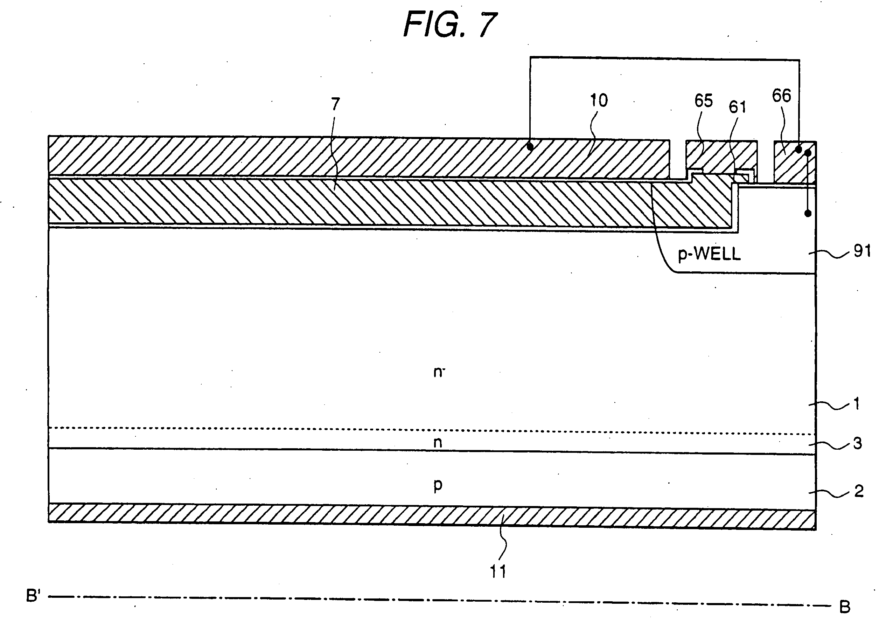

Fig. 5 shows the third embodiment of the present invention and is a plan view of the cell and cell end of the trench insulating gate type IGBT relating to the first embodiment of the present invention. Figs. 6 and 7 are cross sectional views of A-A' and B-B' shown in Fig. 5 respectively.

In the direction of the channel width (see Fig. 7) of the trench insulating gates 7, the p-type well layer 91 is formed at a distance of Lp from the p-type base layer 4 so as to touch the end of the trench insulating gates 7 and be separated from the p-type base layer 4. The distance Lp is preset to a distance which the p-type base layer 4 and the p-type well layer 91 punch through in the voltage inhibition state of the IGBT. In the direction of the channel length (see Fig. 6) of the trench insulating gates 7, the p-type well layer 91 is formed at a distance of Lp from the p-type base layer 9 so as to be separated from the p-type well layer 9 in contact with the p-type base layer 4 in the outermost periphery. The distance Lp is preset to a distance which the p-type well layer 9 and the p-type well layer 91 punch through in the voltage inhibition state of the IGBT. The p-type well layer 91 is electrically connected to the main electrode 10 via the electrode 66. To pull out holes during turn-off, the p-type well layer 9 in the outermost periphery may come in contact with the electrode 10 like the contact 67.

In this embodiment, in the state that a positive voltage is applied to the main electrodes 11 and a negative voltage is applied to the main electrode 10, the p-type base layer 4, the p-type well layer 9, and the p-type well layer 91 punch through and at the end of the p-type base layer 4, the electrostatic concentration is prevented and the withstand voltage reduction is prevented. According to this embodiment, the p-type base layer 4 positioned in the area Lb can be electrically insulated from the p-type well layer 91 without reducing the main withstand voltage, and holes accumulated in the p-type base layer 4 are not ejected outside the element, and the ON voltage is lowered.

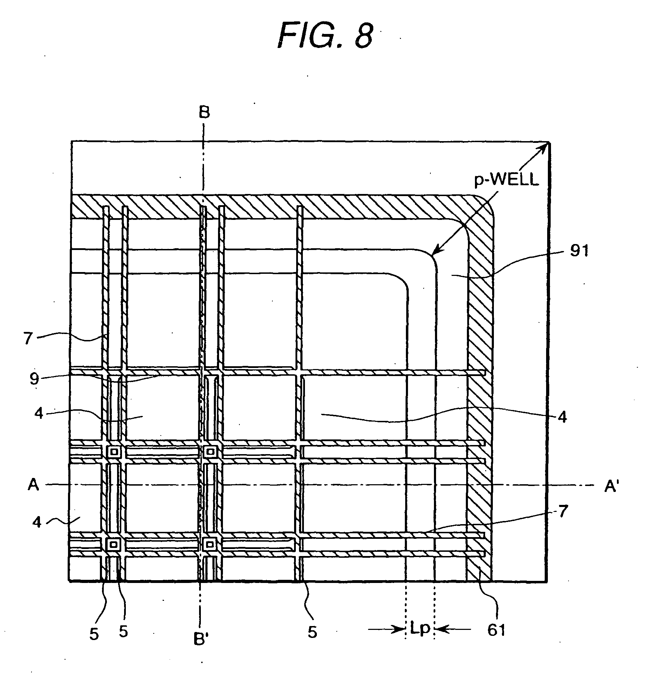

Fig. 8 is a plan view of the third embodiment of the present invention and the basic constitution is the same as that of the first embodiment. The cross sectional views of A-A' and B-B' shown in Fig. 8 are those shown in Figs . 6 and 7 respectively.

The trench insulating gates 7 formed so as to be repeated alternately like the area La and the area Lb are arranged to intersect the trench insulating gates 7 indicated in the second embodiment. 100 to 20000 trench insulating gates in total or so are formed in an actual element. The p-type well layer 9 may not be formed in the area Lb.

According to this embodiment, the gate wire resistance can be reduced.

Therefore, the difference in the delay between a gate signal of the IGBT near to the gate electrode pad or gate input terminal and a gate signal of the IGBT far from it is made smaller, so that the uniformity of the switching operation in the element is improved. Therefore, the element destruction due to current concentration caused by an ununiform operation can be prevented.

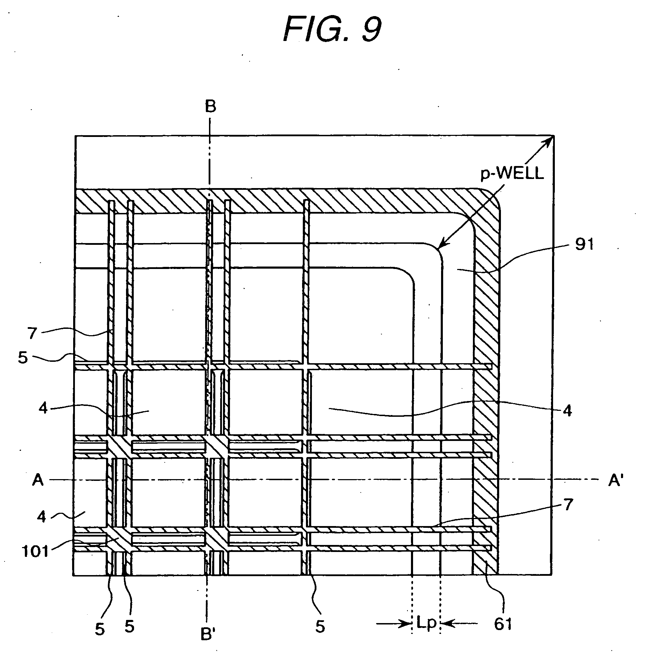

As a deformation example of this embodiment, as shown in Fig. 9, trench insulating gate electrodes can be structured in the area 101 where the two narrow areas La intersect each other and furthermore, the gate resistance can be reduced.

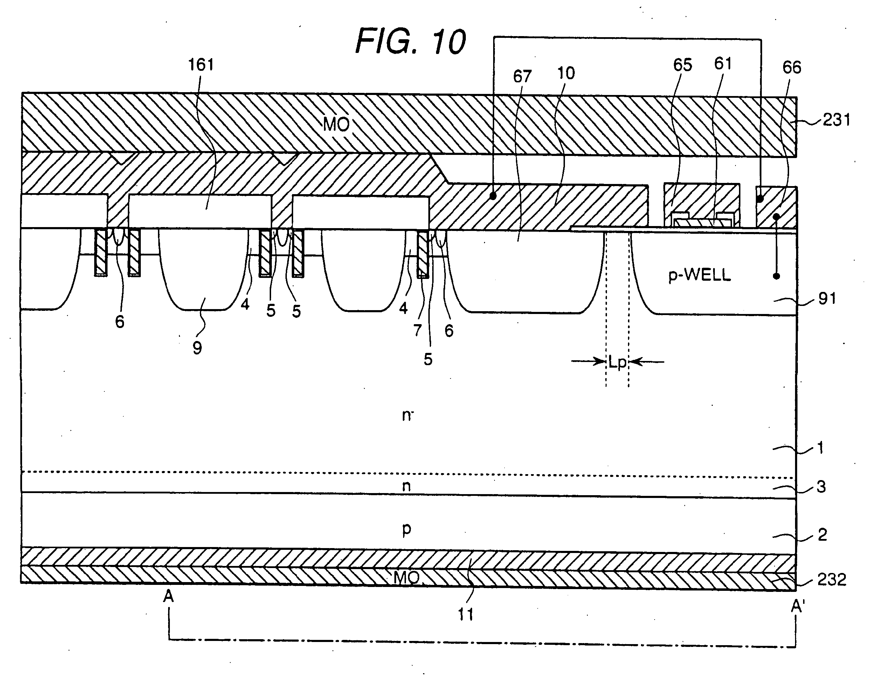

Fig. 10 shows the fifth embodiment of the present invention and is a cross sectional view of an IGBT chip. The basic constitution is the same as that of the first embodiment. The plane shape of the trench insulating gates is formed in a mesh-shape as shown in Fig. 8. Numerals 231 and 232 indicate an emitter electrode member and a collector electrode member respectively. The emitter electrode member 231 and the collector electrode member 232 are in contact with the main electrodes 10 and 11 by pressure respectively. These electrode members, in this embodiment, use molybdenum Mo whose coefficient of heat expansion is close to that of a semiconductor layer as a material. Numeral 61 indicates a gate electrode, which is separated from the pressure portion and attached with the conductive metal electrode 65 so as to form a resistor. Under the main electrode 10, the insulating film 161 is formed thicker or higher than the gate electrode 61 and the insulating film around them. As a result, the top of the main electrode 10 is formed higher than the metal electrode 65 on the gate electrode 61 and the emitter electrode member 231 is not in contact with the metal electrode 65 on the gate electrode. Since the metal electrode 65 for reducing the gate wire resistance is provided, the delay of a gate signal to be transferred to the IGBT can be suppressed. Therefore, the switching delay between the IGBT unit near to the gate pad and the IGBT far from the gate pad is reduced and the current concentration to the IGBT units and heat destruction by it can be prevented. In this embodiment, the trench insulating gates 7 are arranged so as to intersect each other. As indicated by this embodiment 1, the gate input capacity in this structure can be reduced and also the delay of a gate signal can be suppressed and by pressurizing the main electrodes 10 and 11, the emitter electrode and collector electrode can come into contact with each other.

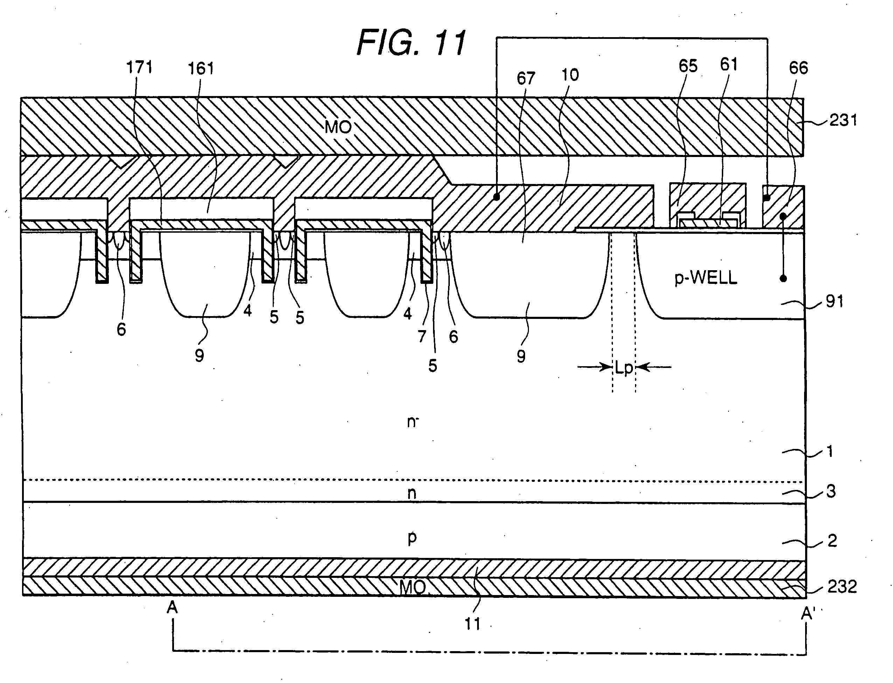

Fig. 11 shows the sixth embodiment of the present invention and is a cross sectional view of an IGBT chip. The basic constitution is the same as that of the sixth embodiment. Under the insulating film 161, the p-type base layer 4 and the p-type well layer 9 are in contact with the trench insulating gate electrodes so as to be separated by an insulating film and the electrodes 171 connecting the insulating gates are formed in the area Lb. The electrodes 171 hold the main electrode 10 high and make the resistance of the gates lower. Although the gate input capacity increases, the difference between the gate input capacity and the feedback capacity does not increase, so that by use of this structure, the delay of a gate signal can be suppressed more. Therefore, by pressurizing the main electrodes 10 and 11, the emitter electrode and collector electrode can come into contact with each other.

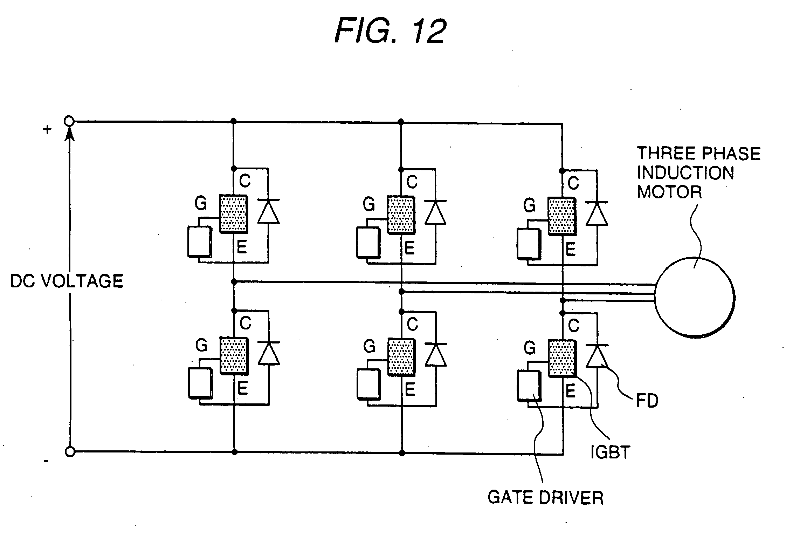

Fig. 12 shows an example of a power converter using the trench insulating gate type IGBT of the present invention which is a circuit diagram showing an embodiment of a 3-phase invertor for driving an induction motor. Between the collector and the emitter of the IGBT, a diode having a reverse polarity for feeding back the load current is connected in parallel and between the gates and the emitter, a gate driver is connected. The two IGBTs connected in series are connected in parallel for three phases respectively. By using the IGBTs of the present invention, the input capacity is reduced, so that the output capacity of the gate driver can be lowered and the gate driver can be miniaturized and lightened. Since the saturation current is equivalent to that of a conventional planar IGBT, there is no need to add a current limit circuit and an invertor circuit which is simple and reliable and causes little loss can be realized.

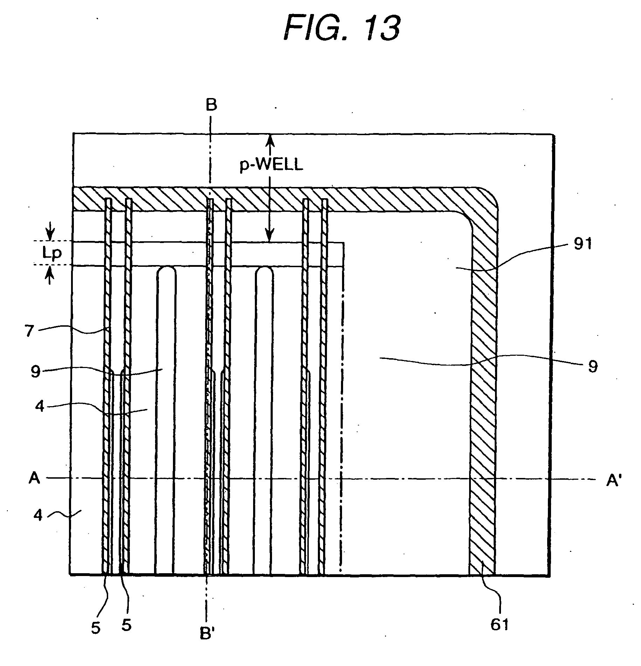

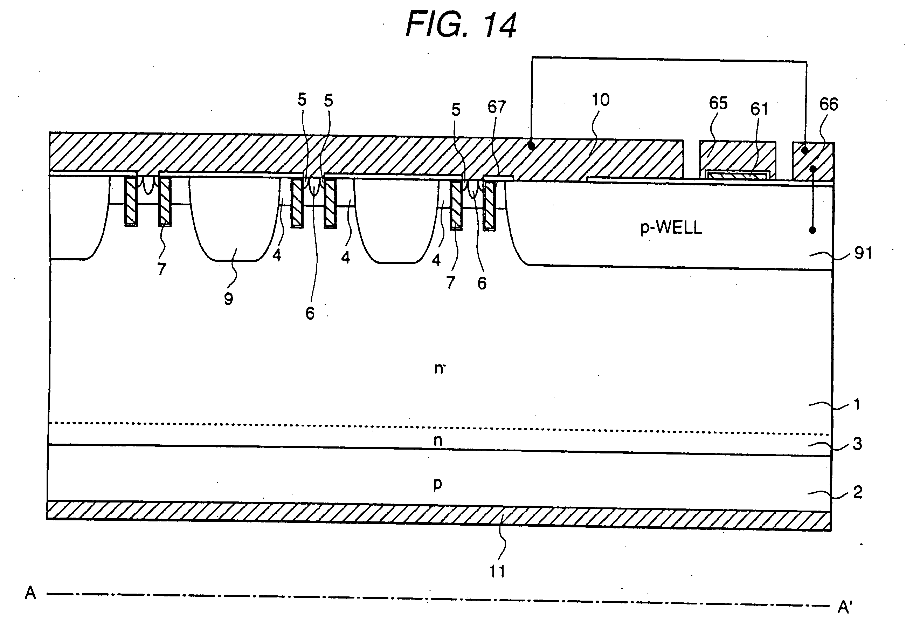

Fig. 13 shows the seventh embodiment of the present invention and is a plan view of the cell and cell end of a trench insulating gate type IGBT. Fig. 14 is a cross sectional view of A-A' shown in Fig. 13.

The basic constitution is the same as that of the fourth embodiment. However, though the p-type well layer 9 positioned in the outermost periphery is not provided in the direction of the channel width of the trench insulating gates 7, the p-type base layer 4 and the p-type well layer 91 are overlaid and in contact with each other. The p-type base layer 4 and the p-type well layer 91 are in contact with the main electrode 10 like the contact 67.

It is desirable to form the p-type well layer 9 and the p-type well layer 91 as a same layer in the same process. The reason is that the production cost can be reduced.

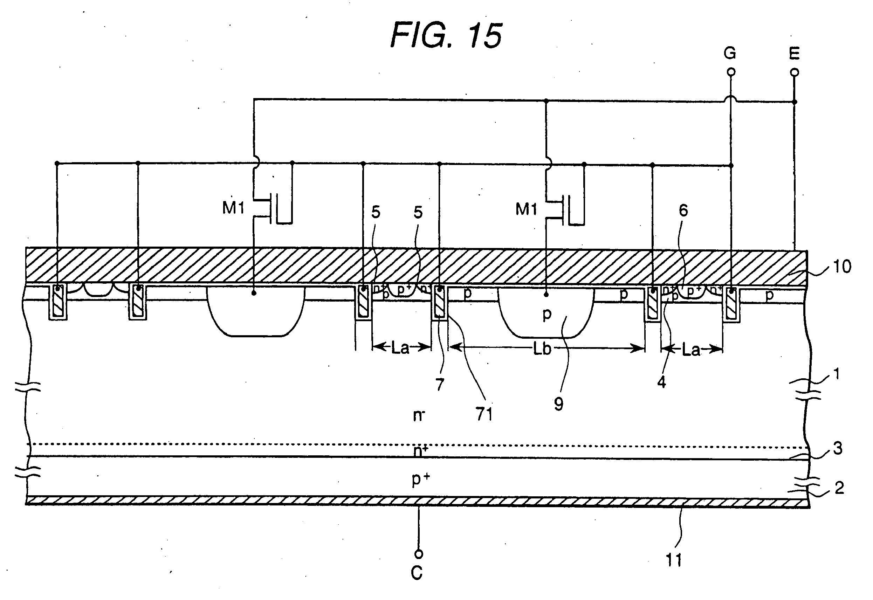

Fig. 15 shows the eighth embodiment of the present invention and the basic constitution is the same as that of the first embodiment. In this embodiment, an M1 source electrode which is a p-type MOS is electrically connected to the p-type well layer 9 and a drain electrode is electrically connected to the main electrode 10. An M1 gate electrode is electrically connected to the trench insulating gates 7.

When the IGBT is turned off, a negative or 0 potential is applied to the trench insulating gates 7.

When the trench insulating gates 7 of the IGBT are turned off by applying a negative potential, M1 may be any one of the enhancement type and the depression type, though when they are turned off by applying a 0 potential, it is necessary to use M1 of the depression type. In either case, when the IGBT is turned on, M1 is turned off and when the IGBT is turned off, M1 is turned on.

When the IGBT is turned off, holes accumulated in the p-type well layer 9 and the p-type base layer 4 pass M1 . As a result, holes can be quickly ejected from the element, so that the turn-off loss is reduced. As a result, the potential of the p-type base layer 4 is not increased and the insulation destruction of the gate oxidized film of the trench insulating gates 7 can be prevented. When the IGBT is turned on, M1 is turned off, so that holes do not flow out of the element from M1.

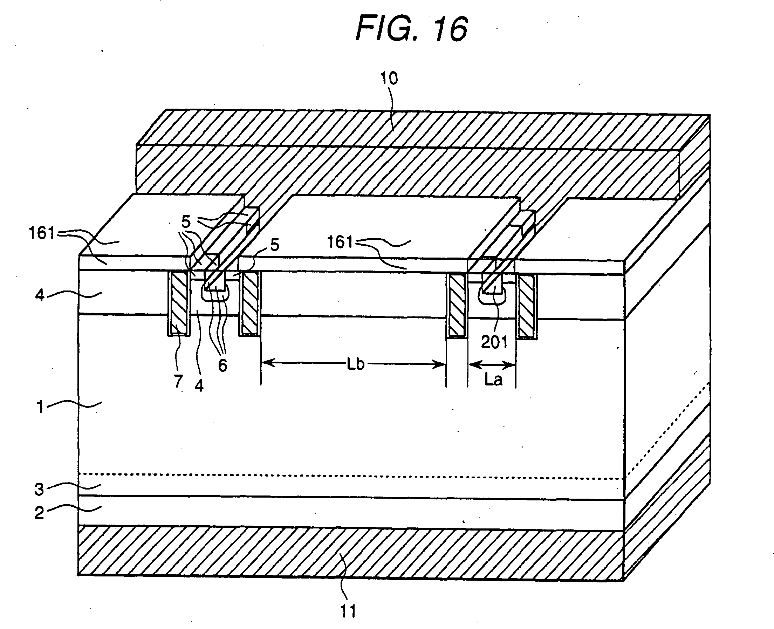

Fig. 16 shows an example useful for understanding the present invention and is a solid perspective view. Although the basic constitution is the same as that shown in Fig. 1, the p-type well layer 9 is not formed in the area Lb and the p-type base layer 4 is formed continuously. Along the longitudinal direction of the trench insulating gates 7, that is, the longitudinal direction of the area La, the n-type source layer 5 is divided into a plurality of areas. Between neighboring areas, a part of the p-type base layer 4 is positioned. Namely, the n-type source layer 5 is formed intermittently. Almost at the center in the width direction of the area La, a groove which is a contact hole 201 is formed in the longitudinal direction so deep as to pass the n-type source layer 5. The area La is divided into two areas by this groove. In these two areas, the n-type source layer 5 is formed respectively in the same way. Although not shown in the drawing, the main electrode 10 (source electrode) is electrically connected to the n-type source layer 5 and the p-type base layer 4 in the same way as with Fig. 1 . Furthermore, in this embodiment, even in the contact hole 201, the main electrode 10 (source electrode) is electrically connected to the n-type source layer 5 and the p-type base layer 4. At the bottom of the contact hole 201, the p+ layer 6 whose impurity density is higher than that of the p-type base layer 4 is formed and the p-type base layer 4 is electrically connected to the main electrode via the p+ layer 6.

In this embodiment, Lb/La is set in the same way as with the embodiment shown in Fig. 1 and the operation and effect previously described by referring to Fig. 2 are produced. Furthermore, in the area La, the n-type source layer 5 is formed intermittently, so that the saturation current Icsat is reduced. Namely, the short-circuit withstand amount is improved. Therefore, as shown in Fig. 2, within the range of 6 > Lb/La > 2 when the ON voltage Von is minimized, Icsat is reduced in the same way as with a case that Lb/La is increased (for example, Lb/La = 12). Therefore the trench insulating gate type IGBT of this embodiment, within the range that the effect of Lb/La on the element withstand voltage is comparatively small, has both low ON voltage and high short-circuit withstand amount. In this embodiment, the p-type base layer 4 is electrically connected to the main electrode at the bottom of the contact hole 201, so that when the IGBT is turned off, the hole current is ejected to the main electrode 10 without almost passing in the neighborhood of the n-type source layer 5. Therefore, the latch-up phenomenon at the time of turn-off is hardly generated.

According to the present invention, a high performance trench insulating gate type IGBT can be realized.

## Claims

1. A semiconductor device comprising:
a first semiconductor layer (2) of a first conductive type,
a second semiconductor layer (1) of a second conductive type neighboring to said first semiconductor layer (2),
a third semiconductor layer (4) of said first conductive type neighboring to said second semiconductor layer (1),
a plurality of insulated gates (7) passing through said third semiconductor layer (4) and reaching said second semiconductor layer (1),
a first area and a second area which are areas between said neighboring insulated gates (7) and neighboring to each other,
a fourth semiconductor layer (5) of said second conductive type in contact with said insulated gates (7) in said third semiconductor layer (4) in said first area,
a first main electrode (10) electrically connected to said third semiconductor layer (4) and said fourth semiconductor layer (5) in said first area, and
a second main electrode (11) electrically connected to said first semiconductor layer (2), wherein:
an interval between said neighboring insulated gates (7) in said second area is larger than an interval between said neighboring insulated gates (7) in said first area, and
assuming said interval between said neighboring insulated gates (7) in said first area as La and said interval between said neighboring insulated gates in said second area as Lb, La ≤ 5µm and Lb/La > 1; and
**characterised in that**:
a p-type well layer (91) is provided at an end of the most peripheral part of said semiconductor device and is in contact with said first main electrode (10) said p-type well layer (91) being deeper than said third semiconductor layer (4);
said insulated gates (7) between said first and second areas are provided on said p-type well layer (91) at an end of the most peripheral part of said semiconductor device and are in contact with a gate electrode (61) of the p-type well layer (91); and
a fifth semiconductor layer (9) of said first conductive type either
(i) deeper than said third semiconductor layer (4) or
(ii) deeper than the bottom of said insulated gates (7)
is installed in said second area, and said first main electrode (10) is insulated from said fifth semiconductor layer (9) by an insulating film.

2. A semiconductor device according to claim 1, wherein 6 ≥ Lb/La ≥ 2.

3. A semiconductor according to claim 1 or 2, wherein said third semiconductor layer in said second area and said first electrode are insulated by an insulating film.

4. A semiconductor device according to claim 3, wherein said third semiconductor layer in said first area and said third semiconductor layer in said second area are separated from each other.

5. A semiconductor device according to claim 1 or 2, wherein a fifth semiconductor layer of said first conductive type deeper than said third semiconductor layer is installed in said second area.

6. A power converter comprising:
a pair of DC terminals,
a plurality of series connection circuits connected between said DC terminals in which a plurality of semiconductor switching elements are connected in series, and
a plurality of AC terminals connected to each DC series connection point of said plurality of DC connection circuits and
converting power by turning said plurality of semiconductor switching elements on or off, wherein:
each of said plurality of semiconductor switching elements is a semiconductor device according to any one of claims 1 to 5.

## Patentansprüche

1. Halbleiterelement mit:
einer ersten Halbleiterschicht (2) eines ersten Leittyps,
einer zweiten Halbleiterschicht (1) eines zweiten Leittyps, die zur ersten Halbleiterschicht (2) benachbart ist,
einer dritten Halbleiterschicht (4) des ersten Leittyps, die zur zweiten Halbleiterschicht (1) benachbart ist,
mehreren isolierten Gates (7), die durch die dritte Halbleiterschicht (4) verlaufen und die zweite Halbleiterschicht (1) erreichen,
einem ersten und einem zweiten Bereich, die zwischen den benachbarten isolieren Gates (7) liegen und zueinander benachbart sind,
einer vierten Halbleiterschicht (5) des zweiten Leittyps, die in dem ersten Bereich mit den isolierten Gates (7) in der dritten Halbleiterschicht (4) in Kontakt ist,
einer ersten Hauptelektrode (10), die in dem ersten Bereich mit der dritten Halbleiterschicht (4) und der vierten Halbleiterschicht (5) elektrisch verbunden ist, und
einer zweiten Hauptelektrode (11), die mit der ersten Halbleiterschicht (2) elektrisch verbunden ist, wobei:
in dem zweiten Bereich ein Abstand zwischen den benachbarten isolierten Gates (7) größer ist als ein Abstand zwischen den benachbarten isolierten Gates (7) in dem ersten Bereich, und
unter der Annahme, dass der Abstand zwischen den benachbarten isolierten Gates (7) in dem ersten Bereich La und der Abstand zwischen den benachbarten isolierten Gates in dem zweiten Bereich Lb ist, La ≤ 5µm und Lb/La > 1; und
**dadurch gekennzeichnet, dass**:
eine p-Typ-Wannenschicht (91) an einem Ende des äußersten Teils des Halbleiterelements vorgesehen und mit der ersten Hauptelektrode (10) in Kontakt ist, wobei die p-Typ-Wannenschicht (91) tiefer als die dritte Halbleiterschicht (4) ist;
die isolierten Gates (7) zwischen den ersten und zweiten Bereichen an einem Ende des äußersten Teils des Halbleiterelements auf der p-Typ-Wannenschicht (91) vorgesehen und in Kontakt mit einer Gate-Elektrode (61) der p-Typ-Wannenschicht (91) sind; und
eine fünfte Halbleiterschicht (9) des ersten Leittyps entweder
(i) tiefer als die dritte Halbleiterschicht (4) oder
(ii) tiefer als die Unterseite der isolierten Gates (7)
in dem zweiten Bereich installiert ist, und die erste Hauptelektrode (10) durch einen Isolierfilm von der fünften Halbleiterschicht (9) isoliert ist.

2. Halbleiterelement nach Anspruch 1, wobei 6 ≥ Lb/La ≥ 2.

3. Halbleiterelement nach Anspruch 1 oder 2, wobei die dritte Halbleiterschicht in dem zweiten Bereich und die erste Elektrode durch einen Isolierfilm isoliert sind.

4. Halbleiterelement nach Anspruch 3, wobei die dritte Halbleiterschicht in dem ersten Bereich und die dritte Halbleiterschicht in dem zweiten Bereich voneinander getrennt sind.

5. Halbleiterelement nach Anspruch 1 oder 2, wobei eine fünfte Halbleiterschicht des ersten Leittyps, die tiefer als die dritte Halbleiterschicht ist, in dem zweiten Bereich installiert ist.

6. Leistungswandler mit:
einem Paar von Gleichstromanschlüssen,
mehreren Reihenverbindungschaltungen, die zwischen die Gleichstromanschlüsse geschaltet sind, in denen mehrere Halbleiterschaltelemente in Reihe verbunden sind, und
mehreren Wechselstromanschlüssen, die mit jedem Gleichstromreihenverbindungspunkt der mehreren Gleichstromverbindungsschaltungen verbunden sind, und
einer Leistungswandlung durch An- oder Ausschalten der mehreren Halbleiterschaltelemente, wobei:
jedes der mehreren Halbleiterschaltelemente ein Halbleiterelement nach einem der Ansprüche 1 bis 5 ist.

## Revendications

1. Dispositif à semi-conducteurs comportant :
une première couche semi-conductrice (2) d'un premier type de conductivité,
une deuxième couche semi-conductrice (1) d'un second type de conductivité voisine de ladite première couche semi-conductrice (2),
une troisième couche semi-conductrice (4) dudit premier type de conductivité voisine de ladite deuxième couche semi-conductrice (1),
une pluralité de grilles isolées (7) traversant ladite troisième couche semi-conductrice (4) et atteignant ladite deuxième couche semi-conductrice (1),
une première zone et une deuxième zone lesquelles sont des zones comprises entre lesdites grilles isolées voisines (7) et voisines l'une de l'autre,
une quatrième couche semi-conductrice (5) dudit second type de conductivité en contact avec lesdites grilles isolées (7) dans ladite troisième couche semi-conductrice (4) de ladite première zone,
une première électrode principale (10) électriquement connectée à ladite troisième couche semi-conductrice (4) et à ladite quatrième couche semi-conductrice (5) dans ladite première zone, et
une seconde électrode principale (11) électriquement connectée à ladite première couche semi-conductrice (2), dans lequel :
un intervalle entre lesdites grilles isolées voisines (7) dans ladite seconde zone est supérieur à un intervalle compris entre lesdites grilles isolées voisines (7) dans ladite première zone, et
en supposant que ledit intervalle entre lesdites grilles isolées voisines (7) dans ladite première zone est La et que ledit intervalle entre lesdites grilles isolées voisines dans ladite seconde zone est Lb, La ≤ 5µm et Lb/La > 1, et
**caractérisé en ce que** :
une couche de puits de type p (91) est agencée au niveau d'une extrémité de la partie la plus périphérique dudit dispositif à semi-conducteurs et est en contact avec ladite première électrode principale (10), ladite couche de puits de type p (91) étant plus profonde que ladite troisième couche semi-conductrice (4),
lesdites grilles isolées (7) comprises entre lesdites première et seconde zones sont agencées sur ladite couche de puits de type p (91) à une extrémité de la partie la plus périphérique dudit dispositif à semi-conducteurs et sont en contact avec une électrode de grille (61) de la couche de puits de type p (91), et
une cinquième couche semi-conductrice (9) dudit premier type de conductivité
(i) soit plus profonde que ladite troisième couche semi-conductrice (4)
(ii) soit plus profonde que la partie inférieure desdites grilles isolées (7)
est disposée dans ladite seconde zone, et ladite première électrode principale (10) est isolée de ladite cinquième couche semi-conductrice (9) par l'intermédiaire d'un film isolant.

2. Dispositif à semi-conducteurs selon la revendication 1, dans lequel 6 ≥ Lb/La ≥ 2.

3. Dispositif à semi-conducteurs selon la revendication 1 ou 2, dans lequel ladite troisième couche semi-conductrice dans ladite seconde zone et ladite première électrode sont isolées par l'intermédiaire d'un film isolant.

4. Dispositif à semi-conducteurs selon la revendication 3, dans lequel ladite troisième couche semi-conductrice dans ladite première zone et ladite troisième couche semi-conductrice dans ladite seconde zone sont séparées l'une de l'autre.

5. Dispositif à semi-conducteurs selon la revendication 1 ou 2, dans lequel une cinquième couche semi-conductrice dudit premier type de conductivité plus profonde que ladite troisième couche semi-conductrice est disposée dans ladite seconde zone.

6. Convertisseur de puissance comportant :
une paire de bornes DC,
une pluralité de circuits de montage en série connectés entre lesdites bornes DC dans lesquels une pluralité d'éléments de commutation à semi-conducteurs sont montés en série, et
une pluralité de bornes AC connectées à chaque point de montage en série DC de ladite pluralité de circuits de montage DC, et
convertissant de la puissance en rendant passant ou en bloquant ladite pluralité d'éléments de commutation à semi-conducteurs, dans lequel :
chaque élément parmi ladite pluralité d'éléments de commutation à semi-conducteurs est un dispositif à semi-conducteurs selon l'une quelconque des revendications 1 à 5.
